# EUROPÄISCHE PATENTANMELDUNG

(11) **EP 3 771 928 A1**
(43) Veröffentlichungstag der Anmeldung: **03.02.2021**
(21) Anmeldenummer: 20186897.3
(22) Anmeldetag: 21.07.2020
(51) Int. Cl.: G01S 17/00, G01S 7/497, G06T 15/06

(54) **SIMULIEREN EINES AKTIVEN OPTISCHEN SENSORSYSTEMS**

(30) Priorität: 01.08.2019 DE 102019120777
(71) Anmelder: Valeo Schalter und Sensoren GmbH, 74321 Bietigheim-Bissingen (DE)
(72) Erfinder: Sergeev, Nikolai, 74321 Bietigheim-Bissingen (DE)
(74) Vertreter: Kluth, Philipp

(57) **Zusammenfassung**

Gemäß einem computerimplementierten Simulationsverfahren zum Simulieren einer Abtastung eines Objekts (15) mit einem aktiven optischen Sensorsystem (7) wird eine Beschreibung einer Objektoberfläche vorgegeben. Mittels einer Recheneinheit (19) wird basierend auf der Beschreibung der Objektoberfläche eine Menge von diskreten Punkten erzeugt und wird für jeden der Punkte eine Antwortfunktion (20) erzeugt, sowie eine Superposition (21) der erzeugten Antwortfunktionen (20) bestimmt. Mittels der Recheneinheit (19) wird eine virtuelle Strahlungsleistung auf einer aktiven Oberfläche des Sensorsystems (7) abhängig von der Superposition (21) bestimmt.

## Beschreibung

Die Erfindung betrifft ein computerimplementiertes Simulationsverfahren zum Simulieren einer Abtastung eines Objekts mit einem aktiven optischen Sensorsystem, ein computerimplementiertes Simulationsverfahren zum Simulieren einer Kalibrierung eines aktiven optischen Sensorsystems sowie eine entsprechende Simulationsvorrichtung, ein Computerprogramm und ein computerlesbares Speichermedium.

Aktive optische Sensorsysteme, wie beispielsweise Lidarsysteme, können an Kraftfahrzeugen montiert werden, um vielfältige Funktionen elektronischer Fahrzeugführungssysteme oder Fahrerassistenzsysteme zu realisieren. Diese Funktionen beinhalten Abstandsmessungen, Abstandsregelalgorithmen, Spurhalteassistenten, Objektverfolgungsfunktionen und so weiter.

Abweichungen einer Einbauposition oder Orientierung eines Sensorsystems von einer nominalen Orientierung beeinflussen die Genauigkeit der Messwerte beziehungsweise deren Interpretation und Auswertung und damit die Zuverlässigkeit und Robustheit der entsprechenden Funktionen. Daher kann es erforderlich sein, das aktive optische Sensorsystem zu kalibrieren, um entsprechende Orientierungs- oder Positionsabweichungen kompensieren zu können.

Bei der Entwicklung oder Weiterentwicklung von Kalibrierungsverfahren ist es gegebenenfalls erforderlich, ein aktives optisches Sensorsystem physisch bereitzustellen und beispielsweise in einem Testkraftfahrzeug zu montieren, um im Betrieb des Kraftfahrzeugs oder in einer speziellen Testumgebung möglichst realistische Punktwolken mittels des aktiven optischen Sensorsystems zu generieren, anhand derer die Kalibrierungsverfahren getestet werden können.

Auch zum Testen der oben genannten Anwendungen des aktiven optischen Sensorsystems oder während der Entwicklung und Weiterentwicklung des aktiven optischen Sensorsystems selbst kann ein Testaufbau notwendig oder wünschenswert sein.

Das Aufbauen und Testen eines aktiven optischen Sensorsystems ist jedoch zeit- und kostenintensiv.

Es ist daher eine Aufgabe der vorliegenden Erfindung, ein verbessertes Konzept zum Simulieren eines aktiven optischen Sensorsystems anzugeben, das eine möglichst realitätsnahe Simulation ermöglicht, um Zeit- und Kosten für einen tatsächlichen Aufbau eines physischen Sensorsystems zu sparen.

Erfindungsgemäß wird diese Aufgabe durch den jeweiligen Gegenstand der unabhängigen Ansprüche gelöst. Weitere Ausführungsformen und vorteilhafte Weiterbildungen sind Gegenstand der abhängigen Ansprüche.

Das verbesserte Konzept beruht auf der Idee, für jeden einer Menge von diskreten Punkten einer Objektoberfläche eine entsprechende Antwortfunktion auf einen virtuellen Laserpuls zu erzeugen und die Antwortfunktionen an einer aktiven Oberfläche des aktiven optischen Sensorsystems zu überlagern, um eine virtuelle Strahlungsleistung zu bestimmen.

Gemäß einem ersten unabhängigen Aspekt des verbesserten Konzepts wird ein computerimplementiertes Simulationsverfahren zum Simulieren einer Abtastung eines Objekts mit einem aktiven optischen Sensorsystem angegeben. Eine Beschreibung einer Objektoberfläche eines Objekts wird vorgegeben. Mittels einer Recheneinheit wird basierend auf der Beschreibung der Objektoberfläche eine Menge von diskreten Punkten, insbesondere auf der Objektoberfläche, erzeugt. Mittels der Recheneinheit wird für jeden der Punkte eine Antwortfunktion erzeugt, welche eine jeweilige Antwort auf einen virtuellen Laserpuls beschreibt, insbesondere durch das Objekt oder die Objektoberfläche an dem entsprechenden Punkt. Mittels der Recheneinheit wird eine Superposition der erzeugten Antwortfunktionen bestimmt, und mittels der Recheneinheit wird eine virtuelle Strahlungsleistung auf einer aktiven Oberfläche des Sensorsystems abhängig von der Superposition bestimmt.

Hier und im Folgenden kann ein aktives optisches Sensorsystem dadurch als solches definiert sein, dass es eine Sendeeinheit mit einer Lichtquelle, insbesondere zum Aussenden von Licht beziehungsweise Lichtpulsen, aufweist. Die Lichtquelle kann insbesondere als Laser ausgestaltet sein. Des Weiteren weist ein aktives optisches Sensorsystem eine Empfangseinheit mit mindestens einem optischen Detektor, insbesondere zum Erfassen von Licht oder von Lichtpulsen, insbesondere reflektierter Anteile des ausgesendeten Lichts, auf. Das aktive optische Sensorsystem ist insbesondere dazu eingerichtet, basierend auf dem detektierten Licht eines oder mehrere Sensorsignale zu erzeugen und zu verarbeiten und/oder auszugeben.

Hier und im Folgenden kann der Begriff "Licht" derart verstanden werden, dass damit elektromagnetische Wellen im sichtbaren Bereich, im Infrarotbereich und/oder im ultravioletten Bereich umfasst sind. Dementsprechend kann auch der Begriff "optisch" derart verstanden werden, dass er sich auf Licht nach diesem Verständnis bezieht.

Bei dem aktiven optischen Sensorsystem handelt es sich insbesondere um ein virtuelles Sensorsystem. Indem die Abtastung des Objekts mittels dem aktiven optischen Sensorsystem simuliert wird, wird gewissermaßen das aktive Sensorsystem selbst simuliert.

Unter der Abtastung des Objekts mit dem Sensorsystem kann hier und im Folgenden das Erzeugen einer Punktwolke, insbesondere einer dreidimensionalen Punktwolke, von Abtastpunkten verstanden werden. Dabei stellt jeder der Abtastpunkte der Punktwolke eine zugehörige Position auf der Objektoberfläche in einem vordefinierten Koordinatensystem, beispielsweise einem Sensorkoordinatensystem, dar. Die Punktwolke enthält mindestens einen Abtastpunkt, vorzugsweise enthält sie jedoch mehrere, beispielsweise mehrere Hundert oder mehrere Tausend Abtastpunkte.

Die Beschreibung der Objektoberfläche enthält insbesondere eine Beschreibung einer geometrischen Form und einer Position, insbesondere bezüglich des Sensorsystems, der Objektoberfläche in einer geeigneten, insbesondere mathematischen, Darstellung. Beispielsweise kann die geometrische Form der Objektoberfläche in beliebigen, insbesondere dreidimensionalen, Koordinaten implizit oder explizit ausgedrückt sein oder in einer Parameterdarstellung. Die Beschreibung kann auch optische Eigenschaften der Objektoberfläche beinhalten, beispielsweise eine, gegebenenfalls ortsabhängige, Reflektivität der Objektoberfläche. Die Beschreibung der Objektoberfläche entspricht dann insbesondere einem Datensatz, der auf einem Datenträger gespeichert ist.

Der virtuelle Laserpuls kann beispielsweise als Laserpuls verstanden werden, wie er von dem zu simulierenden aktiven optischen Sensorsystem ausgesendet werden könnte. Insbesondere handelt es sich nicht um einen tatsächlich existenten Laserpuls. Der virtuelle Laserpuls kann beispielsweise durch eine Wellenlänge, ein Wellenlängenspektrum, eine oder mehrere Linienbreiten, eine Pulsform, eine maximale Intensität, einen zeitlichen Intensitätsverlauf, eine Aussenderichtung und/oder weitere Parameter definiert sein. Bei der Wellenlänge des virtuellen Laserpulses kann es sich beispielsweise um eine Peakwellenlänge des entsprechenden Wellenlängenspektrums handeln.

Der virtuelle Laserpuls wird beispielsweise vorgegeben, indem die entsprechenden, den Laserpuls definierenden Parameter auf dem Datenträger gespeichert werden und/oder durch einen Benutzer über einen Benutzerschnittstelle an die Recheneinheit übertragen werden. Die Antwortfunktionen können beispielsweise abhängig von dem virtuellen Laserpuls, beispielsweise von den ihn definierenden Parametern, erzeugt werden.

Die Menge von diskreten Punkten beinhaltet drei oder mehr diskrete Punkte. In verschiedenen Ausführungsformen beinhaltet die Menge eine Anzahl von Punkten in der Größenordnung von 100, mehreren Hundert, 1000 oder mehreren Tausend diskreten Punkten. Insbesondere kann die Menge von diskreten Punkten als dreidimensionale Objektpunktwolke verstanden werden, wobei jeder der diskreten Punkte auf der Objektoberfläche liegt.

Die Antwortfunktion für einen Punkt entspricht insbesondere einer näherungsweisen oder angenommenen Antwort des Objekts an dem Punkt auf einen eintreffenden Laserstrahl, insbesondere den virtuellen Laserstrahl. Die Antwortfunktion beschreibt insbesondere eine elektromagnetische Welle, beispielsweise Licht, die von dem Punkt ausgesendet werden würde, wenn ein Laserstrahl entsprechend dem virtuellen Laserstrahl auf den Punkt treffen würde.

Die Antwortfunktionen sind insbesondere ortsabhängige Funktionen. Das Erzeugen der Antwortfunktion für einen Punkt beinhaltet insbesondere das Berechnen der Antwortfunktion auf der aktiven Oberfläche oder auf einem Teilbereich oder wenigstens einem Punkt der aktiven Oberfläche.

Dies bedeutet insbesondere, dass das Erzeugen der Antwortfunktion die Propagation der entsprechenden elektromagnetischen Welle von dem jeweiligen Punkt auf der Objektoberfläche durch den Raum und gegebenenfalls durch Komponenten des Sensorsystems bis hin zur aktiven Oberfläche des Sensorsystems berücksichtigt beziehungsweise beinhaltet.

Die Antwortfunktionen beziehungsweise die Superposition der Antwortfunktionen können insbesondere als virtuelle elektromagnetische Strahlung verstanden werden. Die virtuelle elektromagnetische Strahlung beschreibt dabei insbesondere eine virtuelle Reflexion des virtuellen Laserpulses von der Objektoberfläche.

Je nach Orientierung des virtuellen Laserpulses, also je nach Propagationsrichtung des virtuellen Laserpulses und entsprechend je nachdem, auf welchem Teilbereich der Objektoberfläche der virtuelle Laserpuls auf das Objekt treffen würde, können sich die verschiedenen Antwortfunktionen voneinander unterscheiden. Unterschiedliche Antwortfunktionen können beispielsweise unterschiedliche Amplituden und/oder Phasen aufweisen.

Die Amplitude der jeweiligen Antwortfunktion kann insbesondere von dem Abstand zwischen Sensorsystem und dem Punkt dem entsprechenden Punkt auf der Objektoberfläche abhängen sowie von der Reflektivität der Objektoberfläche an diesem Punkt. Diese Informationen beziehungsweise Parameter sind beispielsweise durch die Beschreibung der Objektoberfläche gegeben.

Insbesondere manche der Antwortfunktionen gleich Null sein. Diese Punkte entsprechen dann beispielsweise Punkten, auf die der virtuelle Laserstrahl nicht treffen würde.

Das Erzeugen der Antwortfunktionen beinhaltet insbesondere das Berechnen der Antwortfunktionen, jedenfalls das Berechnen der Antwortfunktionen auf der aktiven Oberfläche, dem Teilbereich oder dem wenigstens einen Punkt der aktiven Oberfläche, und das Speichern des entsprechenden Berechnungsergebnisses auf dem Datenträger.

Die virtuelle Strahlungsleistung kann ebenfalls eine Funktion des Ortes auf der aktiven Oberfläche sein. Beispielsweise kann die Strahlungsleistung eine diskrete Funktion auf der aktiven Oberfläche sein.

Insbesondere kann die aktive Oberfläche des Sensorsystems durch jeweilige individuelle aktive Oberflächen einzelner optischer Detektoren des Sensorsystems, welche beispielsweise als Fotodioden oder Avalanche-Fotodioden ausgestaltet sein können, gebildet werden.

Die Strahlungsleistung kann beispielsweise eine diskrete Funktion sein, wobei für jede individuelle aktive Oberfläche der Detektoren ein entsprechender Wert der Strahlungsleistung gegeben sein kann.

Die Bestimmung der virtuellen Strahlungsleistung auf der aktiven Oberfläche kann als Ergebnis der Simulation verstanden werden. Insbesondere ist eine Sensorantwort, beispielsweise eines oder mehrere Sensorsignale, des aktiven optischen Sensorsystems durch die Strahlungsleistung eindeutig vorgegeben.

Durch die bestimmte Strahlungsleistung, beispielsweise durch einen Detektionsort oder eine räumliche Verteilung der Strahlungsleistung auf der aktiven Oberfläche, kann ein Abtastpunkt der Punktwolke simuliert werde. Dazu können beispielsweise eine Laufzeit des virtuellen Laserpulses, die Antwortfunktionen und/oder eine virtuelle Aussenderichtung des virtuellen Laserpulses berücksichtigt werden.

Durch die Modellierung der Objektoberfläche durch diskrete Punkte und die Berechnung der Antwortfunktionen sowie deren Überlagerung an der aktiven optischen Oberfläche des Sensorsystems wird die Objektoberfläche beispielsweise als Ansammlung freier oder quasifreier elektrischer Ladungen behandelt. Diese werden durch den virtuellen Laserpuls angeregt und senden daraufhin selbst elektromagnetische Wellen aus, deren Wellenlänge insbesondere gegeben ist durch die Wellenlänge des virtuellen Laserpulses, beispielsweise gleich oder näherungsweise gleich der Wellenlänge des virtuellen Laserpulses ist. Die von den Ladungen ausgesendeten elektromagnetischen Wellen können durch unterschiedliche Arten von Wellen approximiert werden. Beispielsweise können die Antwortfunktionen jeweils als Kugelwellen bestimmt werden.

Wie durch Vergleiche mit realen Systemen gezeigt werden kann, ist es mittels des verbesserten Konzepts möglich, eine realitätsnahe Simulation des optischen Sensorsystems beziehungsweise der Abtastung des Objekts zu erzielen.

Mit dem Simulationsergebnis können Algorithmen zur Kalibrierung eines aktiven optischen Sensorsystems oder zur Auswertung von Messergebnissen eines aktiven optischen Sensorsystems getestet werden, oder es kann ein Verhalten eines tatsächlichen oder zu entwickelnden aktiven optischen Sensors in der Realität vorab getestet werden.

Damit ist es möglich, Zeit-, Ressourcen- und und Kostenaufwand zum Aufbau tatsächlicher Sensorsysteme und zum Durchführen entsprechender Tests einzusparen.

Gemäß zumindest einer Ausführungsform sind die Antwortfunktionen bis auf einen jeweiligen Skalierungsfaktor identisch zueinander, wobei der Skalierungsfaktor von einer Reflektivität der Objektoberfläche an dem jeweiligen Punkt und/oder von dem Abstand des jeweiligen Punktes von dem Sensorsystem abhängt.

Die Beschreibung der Objektoberfläche enthält beispielsweise jeweilige Werte für die Reflektivität und/oder den Abstand für jeden der Punkte.

Gemäß zumindest einer Ausführungsform des computerimplementierten Simulationsverfahrens zum Simulieren der Abtastung des Objekts wird eine Intensität des virtuellen Laserpulses vorgegeben. Die Antwortfunktionen werden mittels der Recheneinheit in Abhängigkeit von der Intensität des virtuellen Laserpulses erzeugt.

Gemäß zumindest einer Ausführungsform werden die Antwortfunktionen mittels der Recheneinheit jeweils als Kugelwelle erzeugt. Das heißt, für einen gegebenen Punkt der Menge von diskreten Punkten ist die erzeugte Antwortfunktion gleich einer Kugelwelle.

Gemäß zumindest einer Ausführungsform werden die Antwortfunktionen mittels der Recheneinheit als Kugelwellen oder sonstige Wellen erzeugt, wobei eine Wellenlänge der Kugelwellen beziehungsweise der sonstigen Wellen gleich oder näherungsweise gleich der Wellenlänge des virtuellen Laserpulses ist.

Gemäß zumindest einer Ausführungsform wird mittels der Recheneinheit abhängig von der Strahlungsleistung ein virtueller Abtastpunkt, beispielsweise einer virtuellen Punktwolke, erzeugt.

Gemäß zumindest einer Ausführungsform weist das aktive optische Sensorsystem eine Sendeeinheit, beispielsweise mit einer Laserquelle, auf, um Licht, insbesondere Laserstrahlen, mit verschiedenen Aussendewinkeln innerhalb einer Sendeebene des Sensorsystems auszusenden.

Gemäß zumindest einer Ausführungsform weist das aktive optische Sensorsystem eine Empfangseinheit auf. Die Empfangseinheit ist dazu eingerichtet, reflektierte Anteile des von der Sendeeinheit ausgesandten Lichts zu detektieren und basierend darauf wenigstens ein Sensorsignal zu erzeugen.

Gemäß zumindest einer Ausführungsform beinhaltet die Empfangseinheit wenigstens einen, beispielsweise drei oder mehr, optische Detektoren, die insbesondere als Fotodioden oder Avalanche-Fotodioden ausgestaltet sind.

Das aktive optische Sensorsystem weist in verschiedenen Ausführungsformen eine Verarbeitungseinheit auf, die mit der Empfangseinheit, insbesondere mit den optischen Detektoren, gekoppelt ist, um das wenigstens eine Sensorsignal zu empfangen. Die Verarbeitungseinheit ist dazu eingerichtet, abhängig von dem wenigstens einen Sensorsignal, insbesondere abhängig von einer Lichtlaufzeit und insbesondere abhängig von der Aussenderichtung des Lichts, das von der Sendeeinheit ausgesandt wird, einen oder mehrere Abtastpunkte zu erzeugen. Dazu kann die Verarbeitungseinheit beispielsweise die Lichtlaufzeit berechnen.

Gemäß zumindest einer Ausführungsform weist das Sensorsystem eine Welle auf, die drehbar gelagert ist, insbesondere um eine Rotationsachse, die senkrecht auf der Sendeebene steht.

Gemäß zumindest einer Ausführungsform weist das Sensorsystem einen Spiegel auf, der mit der Welle verbunden ist und um die Drehachse drehbar ist.

Insbesondere kann die Sendeeinheit den Laserpuls erzeugen und der Laserpuls wird auf den Spiegel geleitet. Je nach Drehposition des Spiegels werden ein Aussendewinkel oder eine Aussenderichtung des Laserpulses beziehungsweise eine Propagationsrichtung des Laserpulses definiert.

Gemäß zumindest einer Ausführungsform weist das Sensorsystem einen Drehgeber auf, der Welle gekoppelt ist, um eine Drehposition des Spiegels zu bestimmen.

Gemäß zumindest einer Ausführungsform weist das Sensorsystem eine Optikeinheit auf, welche insbesondere wenigstens eine Linse beinhaltet. Die wenigstens eine Linse ist in einem Strahlengang zwischen der Sendeeinheit und dem Spiegel angeordnet.

Gemäß zumindest einer Ausführungsform wird wenigstens ein geometrischer Parameter zur Beschreibung des Sensorsystems und/oder zur Beschreibung des Objekts vorgegeben. Die Superposition wird mittels der Recheneinheit abhängig von dem wenigstens einen geometrischen Parameter erzeugt.

Der wenigstens eine geometrische Parameter beinhaltet beispielsweise einen ersten Parameter, welcher einen Aufbau des Sensorsystems beschreibt.

Der wenigstens eine geometrische Parameter beinhaltet beispielsweise wenigstens einen zweiten Parameter, der eine Pose des Sensorsystems oder einer oder mehrerer Komponenten des Sensorsystems, beispielsweise eines oder mehrerer Detektoren, der Optikeinheit, der Linse, des Spiegels oder einer weiteren Komponente, beschreibt.

Als Pose kann hier und im Folgenden Position, eine Orientierung oder eine Kombination aus Position und Orientierung verstanden werden.

Der wenigstens eine geometrische Parameter kann beispielsweise wenigstens einen dritten Parameter beinhalten, der eine Pose des Objekts beschreibt.

Der wenigstens eine geometrische Parameter zur Beschreibung des Sensorsystems und/oder der wenigstens eine geometrische Parameter des Objekts können beispielsweise relevante Abstände oder optische Weglängen von dem Objekt zu dem Sensorsystem, insbesondere zu der aktiven Oberfläche, betreffen oder definieren. Dementsprechend hängen die Antwortfunktionen an der aktiven Oberfläche beispielsweise von den geometrischen Parametern ab.

Durch die Berücksichtigung des oder der geometrischen Parameter kann damit die Genauigkeit des Simulation verbessert werden.

Gemäß zumindest einer Ausführungsform wird wenigstens ein Materialparameter zur Beschreibung des Sensorsystems vorgegeben. Die Superposition wird mittels der Recheneinheit abhängig von dem wenigstens einen Materialparameter bestimmt.

Der wenigstens eine Materialparameter kann beispielsweise einen Brechungsindex, insbesondere einen komplexen Brechungsindex oder einen Realteil des Brechungsindex, einen Absorptionsindex oder einen sonstigen relevanten optischen Parameter des Sensorsystems beinhalten, insbesondere eines oder mehrerer Komponenten des Sensorsystems, beispielsweise des Spiegels, der Optikeinheit und/oder der wenigstens einen Linse.

Der wenigstens eine Materialparameter beeinflusst beispielsweise die optische Weglänge von der Objektoberfläche bis zu der aktiven Oberfläche des Sensorsystems. Zudem kann eine Phasenlage der entsprechenden Antwortfunktion an der aktiven Oberfläche durch den wenigstens einen Materialparameter beeinflusst werden.

Da die Antwortfunktionen an der aktiven Oberfläche superponiert werden, kann die Berücksichtigung des wenigstens einen Materialparameters die Genauigkeit der Simulation verbessern.

Gemäß zumindest einer Ausführungsform wird wenigstens ein weiterer Materialparameter zur Beschreibung des Objekts vorgegeben. Die Antwortfunktionen werden mittels der Recheneinheit abhängig von dem wenigstens einen weiteren Materialparameter bestimmt.

Der wenigstens eine Materialparameter kann beispielsweise einen oder mehrere Brechungsindizes, beispielsweise komplexe oder reelle Brechungsindizes, Absorptionsindizes oder Reflektivitäten des Objekts beinhalten.

Insbesondere kann das Objekt an der Objektoberfläche unterschiedliche Materialien aufweisen. Dann kann der wenigstens eine Materialparameter unterschiedliche Materialparameter der verschiedenen Materialien beinhalten.

Durch die Berücksichtigung des wenigstens einen weiteren Materialparameters kann damit insbesondere der Möglichkeit Rechnung getragen werden, dass an der Objektoberfläche an verschiedenen Punkte verschiedene Antwortfunktionen mit verschiedenen Amplituden und/oder Phasenlagen aufgrund unterschiedlicher Materialeigenschaften resultieren. Dementsprechend kann die Genauigkeit der Simulation dadurch weiter verbessert werden.

Gemäß zumindest einer Ausführungsform wird mittels der Recheneinheit abhängig von der virtuellen Strahlungsleistung wenigstens ein virtuelles Sensorsignal erzeugt.

Dementsprechend wird durch die Erzeugung des virtuellen Sensorsignals, insbesondere unter Berücksichtigung von Parametern, beispielsweise charakteristischen Kennwerten oder Kennkurven der einzelnen Detektoren, eine realitätsnähere und dadurch genauere Simulation ermöglicht.

Insbesondere wenn die Detektoren der Empfangseinheit als Avalanche-Fotodioden ausgebildet sind, können diese jeweils eine Ausgangsspannung aufweisen, die von der jeweiligen Strahlungsleistung auf der entsprechenden individuellen aktiven Oberfläche abhängt beziehungsweise dazu proportional ist. Das wenigstens eine virtuelle Sensorsignal kann dann beispielsweise wenigstens eine virtuelle strahlungsleistungsabhängige Ausgangsspannung der Detektoren beinhalten.

Gemäß zumindest einer Ausführungsform wird mittels der Recheneinheit die virtuelle Strahlungsleistung auf der aktiven Oberfläche abhängig von der Superposition ortabhängig bestimmt. Mittels der Recheneinheit werden abhängig von der ortsabhängigen oder ortsabhängig bestimmten virtuellen Strahlungsleistung wenigstens zwei virtuelle Sensorsignale erzeugt.

"Ortsabhängig" kann dabei insbesondere derart verstanden werden, dass die Strahlungsleistung für unterschiedliche Orte auf der aktiven Oberfläche bestimmt wird, insbesondere diskret oder kontinuierlich, also beispielsweise für wenigstens zwei Punkte oder Bereiche auf der aktiven Oberfläche.

Insbesondere beinhalten die wenigstens zwei virtuellen Sensorsignale jeweils ein virtuelles Sensorsignal für jeden der Detektoren der Empfangseinheit. Mit anderen Worten ist jedes der wenigstens zwei virtuellen Sensorsignale genau einem der Detektoren zugeordnet und jeder der Detektoren ist genau einem der wenigstens zwei virtuellen Sensorsignale zugeordnet.

Gemäß zumindest einer Ausführungsform wird die Aussenderichtung des virtuellen Laserpulses vorgegeben. Die Antwortfunktionen werden mittels der Recheneinheit abhängig von der Aussenderichtung erzeugt.

Dadurch kann, insbesondere zusammen mit der ortsabhängigen virtuellen Strahlungsleistung und der Laufzeit, eine dreidimensionale Abtastung simuliert werden.

Gemäß zumindest einer Ausführungsform wird mittels der Recheneinheit die Lichtlaufzeit abhängig von der Beschreibung der Objektoberfläche berechnet. Mittels der Recheneinheit wird abhängig von der Lichtlaufzeit und der virtuellen Strahlungsleistung, insbesondere der ortsabhängig bestimmten virtuellen Strahlungsleistung, ein Abtastpunkt einer virtuellen Punktwolke erzeugt.

Bei der Lichtlaufzeit handelt es sich insbesondere um die Summe einer Lichtlaufzeit des virtuellen Laserpulses von der Sendeeinheit bis zu einem entsprechenden Auftrittspunkt auf der Objektoberfläche und einer entsprechenden Lichtlaufzeit der jeweils relevanten Antwortfunktionen von der Objektoberfläche bis zur aktiven Oberfläche des Sensorsystems, also des reflektierten virtuellen Lichtpulses.

Die Lichtlaufzeit ist insbesondere äquivalent zu einem entsprechenden Abstand des jeweiligen Punkts auf der Objektoberfläche zu dem Sensorsystem.

Gemäß zumindest einer Ausführungsform werden die beschriebenen Schritte, beispielsweise für mehrere Aussenderichtungen des virtuellen Laserpulses, wiederholt, um eine virtuelle Punktwolke zu erzeugen.

Gemäß einem weiteren unabhängigen Aspekt des verbesserten Konzepts wird ein computerimplementiertes Simulationsverfahren zum Simulieren einer Kalibrierung eines aktiven optischen Sensorsystems angegeben. Dabei wird eine Abtastung eines Objekts anhand eines computerimplementierten Simulationsverfahrens zum Simulieren einer Abtastung des Objekts mit dem aktiven optischen Sensorsystem nach dem verbesserten Konzept simuliert. Mittels der Recheneinheit wird abhängig von der Abtastung, insbesondere von der virtuellen Strahlungsleistung, eine virtuelle Punktwolke von Abtastpunkten erzeugt. Mittels der Recheneinheit wird abhängig von der virtuellen Punktwolke eine virtuelle Winkellage des Sensorsystems bestimmt.

Die Simulation der Abtastung wird insbesondere anhand einer Ausführungsform des Verfahrens zum Simulieren der Abtastung nach dem verbesserten Konzept durchgeführt, bei welchem die virtuelle Strahlungsleistung auf der aktiven Oberfläche ortsabhängig bestimmt wird, bei welcher die Aussenderichtung des virtuellen Laserpulses vorgegeben wird und bei welcher die Lichtlaufzeit abhängig von der Beschreibung der Objektoberfläche berechnet wird.

Die virtuelle Winkellage des Sensorsystems kann beispielsweise durch einen Nickwinkel, einen Gierwinkel und einen Rollwinkel des Sensorsystems definiert sein. Nick-, Gierbeziehungsweise Rollwinkel des Sensorsystems sind dabei insbesondere als Rotationswinkel oder Euler-Winkel des Sensorkoordinatensystems bezüglich eines nominalen Sensorkoordinatensystems nach einer vorgegebenen Konvention definiert.

Die Konvention kann beispielsweise derart sein, dass sich das Sensorkoordinatensystem aus dem nominalen Sensorkoordinatensystem durch die folgenden drei Rotationen ergibt, wobei davon ausgegangen wird, dass das Sensorkoordinatensystem und das nominelle Sensorkoordinatensystem zunächst identisch sind. Das Sensorkoordinatensystem wird um den Gierwinkel um die Z-Achse des nominalen Sensorkoordinatensystems rotiert. Danach wird das resultierende Sensorkoordinatensystem um den Nickwinkel um die resultierende Y-Achse des resultierenden Sensorkoordinatensystems rotiert. Danach wird das resultierende Sensorkoordinatensystem um den Rollwinkel um die resultierende X-Achse des resultierenden Sensorkoordinatensystems rotiert. Andere Konventionen sind ebenso möglich.

Es sind Verfahren zur Bestimmung der Winkellage, also zur Kalibrierung, eines aktiven optischen Sensorsystems bekannt. Dabei können beispielsweise Kalibriertargets als abzutastendes Objekt eingesetzt werden. Die virtuelle Winkellage kann analog zu einem dieser bekannten Verfahren bestimmt werden.

Gemäß zumindest einer Ausführungsform des computerimplementierten Simulationsverfahrens zum Simulieren der Kalibrierung wird die Abtastung mehrfach, also mindestens zweimal, anhand des computerimplementierten Simulationsverfahrens zum Simulieren der Abtastung des Objekts simuliert. Dabei wird für jede Simulation ein Wert, insbesondere ein Winkel, für die Aussenderichtung des virtuellen Laserpulses vorgegeben. Mittels der Recheneinheit wird abhängig von der mehrfach simulierten Abtastung die virtuelle Punktwolke erzeugt.

Gemäß einem weiteren unabhängigen Aspekt des verbesserten Konzepts wird eine Simulationsvorrichtung zum Simulieren einer Abtastung eines Objekts mit einem aktiven optischen Sensorsystem angegeben. Die Simulationsvorrichtung weist eine Speichereinheit und eine Recheneinheit auf, wobei die Recheneinheit auf die Speichereinheit zugreifen kann. Auf der Speichereinheit ist eine Beschreibung einer Objektoberfläche eines Objekts des Sensorsystems gespeichert. Die Recheneinheit ist dazu eingerichtet, basierend auf der Beschreibung der Objektoberfläche eine Menge von diskreten Punkten zu erzeugen, insbesondere zu berechnen und zu speichern. Die Recheneinheit ist dazu eingerichtet, für jeden der Punkte eine Antwortfunktion zu erzeugen, insbesondere zu berechnen und zu speichern auf der Speichereinheit, wobei die Antwortfunktion eine jeweilige Antwort auf den virtuellen Laserpuls beschreibt. Die Recheneinheit ist dazu eingerichtet, eine Superposition der erzeugten Antwortfunktionen zu bestimmen, insbesondere zu berechnen und auf der Speichereinheit zu speichern, und eine virtuelle Strahlungsleistung auf einer aktiven Oberfläche des Sensorsystems abhängig von der Superposition zu bestimmen, insbesondere zu berechnen und auf der Speichereinheit zu speichern.

Gemäß zumindest einer Ausführungsform ist die Recheneinheit dazu eingerichtet, die virtuelle Strahlungsleistung auf der aktiven Oberfläche abhängig von der Superposition ortsabhängig zu bestimmen und abhängig von der ortsabhängigen virtuellen Strahlungsleistung wenigstens zwei virtuelle Sensorsignale zu erzeugen.

Gemäß zumindest einer Ausführungsform ist auf der Speichereinheit eine Aussenderichtung des virtuellen Laserpulses gespeichert, und die Recheneinheit ist dazu eingerichtet, die Antwortfunktionen abhängig von der Aussenderichtung zu erzeugen.

Gemäß zumindest einer Ausführungsform ist die Recheneinheit dazu eingerichtet, eine Lichtlaufzeit abhängig von der Beschreibung der Objektoberfläche zu berechnen und abhängig von der Lichtlaufzeit und der virtuellen Strahlungsleistung, insbesondere der ortsabhängigen virtuellen Strahlungsleistung, einen Abtastpunkt einer virtuellen Punktwolke zu erzeugen.

Gemäß zumindest einer Ausführungsform ist die Recheneinheit dazu eingerichtet, abhängig von der virtuellen Punktwolke eine virtuelle Winkellage des Sensorsystems zu bestimmen.

Weitere Ausführungsformen der Simulationsvorrichtung nach dem verbesserten Konzept ergeben sich unmittelbar aus den verschiedenen Ausführungsformen der computerimplementierten Simulationsverfahren nach dem verbesserten Konzept und umgekehrt. Insbesondere ist eine Simulationsvorrichtung nach dem verbesserten Konzept dazu eingerichtet oder programmiert, ein computerimplementiertes Simulationsverfahren nach dem verbesserten Konzept durchzuführen oder die Simulationsvorrichtung führt ein computerimplementiertes Verfahren nach dem verbesserten Konzept durch.

Gemäß einem weiteren unabhängigen Aspekt des verbesserten Konzepts wird ein Computerprogramm mit Befehlen angegeben. Bei Ausführung des Computerprogramms durch ein Computersystem, insbesondere durch eine Simulationsvorrichtung nach dem verbesserten Konzept, beispielsweise eine Recheneinheit der Simulationsvorrichtung, veranlassen die Befehle das Computersystem dazu, ein computerimplementiertes Simulationsverfahren nach dem verbesserten Konzept durchzuführen.

Gemäß einem weiteren unabhängigen Aspekt des verbesserten Konzepts wird ein computerlesbares Speichermedium angegeben, auf welchem ein Computerprogramm nach dem verbesserten Konzept gespeichert ist.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen. Es sind somit auch Ausführungen von der Erfindung als erfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale eines ursprünglich formulierten unabhängigen Anspruchs aufweisen. Es sind darüber hinaus Ausführungen und Merkmalskombinationen, insbesondere durch die oben dargelegten Ausführungen, als offenbart anzusehen, die über die in den Rückbezügen der Ansprüche dargelegten Merkmalskombinationen hinausgehen oder von denen abweichen.

In den Figuren zeigen
- Fig. 1: eine schematische Darstellung einer beispielhaften Ausführungsform einer Simulationsvorrichtung nach dem verbesserten Konzept sowie eines aktiven optischen Sensorsystems,
- Fig. 2: eine Sendeeinheit eines aktiven optischen Sensorsystems und
- Fig. 3: ein schematisches Ablaufdiagramm einer beispielhaften Ausführungsform eines computerimplementierten Simulationsverfahrens nach dem verbesserten Konzept.

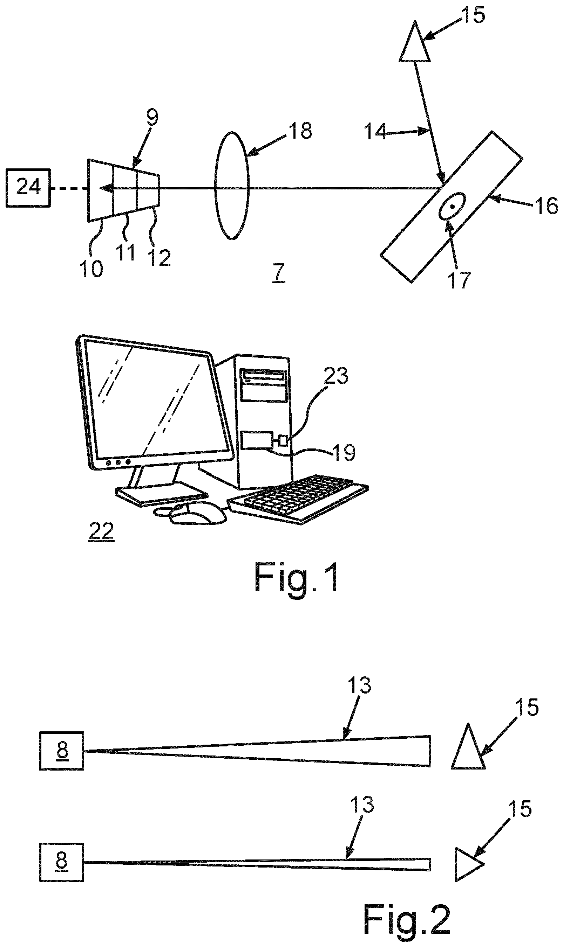

In Fig. 1 ist ein aktives optisches Sensorsystem 7 dargestellt, welches beispielsweise anhand eines Verfahrens und/oder einer Vorrichtung nach dem verbesserten Konzept simuliert werden kann.

Das Sensorsystem 7 ist insbesondere als Lidarsystem ausgebildet und weist eine Sendeeinheit 8 auf, die eine Laserquelle, insbesondere eine Infrarot-Laserquelle, beinhaltet. Mittels der Laserquelle kann die Sendeeinheit 8 Laserpulse 13 mit unterschiedlichen Aussendewinkeln innerhalb einer Sendeebene des Sensorsystems 7 aussenden.

Das Sensorsystem 7 kann auch eine Verarbeitungs- und Steuereinheit 24 aufweisen, die insbesondere mit der Sendeeinheit 8 verbunden sein kann. Insbesondere kann die Verarbeitungs- und Steuereinheit 24 die Sendeeinheit 8 ansteuern, um die Laserpulse 13 auszusenden.

Das Sensorsystem 7 weist außerdem eine Empfangseinheit 9 auf. Die Verarbeitungs- und Steuereinheit 24 ist beispielsweise mit der Empfangseinheit 9 verbunden.

Die Empfangseinheit 9 kann beispielsweise reflektierte Anteile 14 der Laserpulse 13 detektieren und basierend darauf wenigstens ein Sensorsignal erzeugen und an die Verarbeitungs- und Steuereinheit 24 übermitteln.

Die Empfangseinheit 9 beinhaltet wenigstens einen, im Beispiel der Fig. 1 drei, optische Detektoren 10, 11, 12, die insbesondere nebeneinander linear entlang einer Achse parallel zu einer Welle 17 angeordnet und beispielsweise als Avalanche-Fotodioden ausgestaltet sind.

Das Sensorsystem 7 weist außerdem eine Optikeinheit mit wenigstens einer Linse 18 auf sowie einen Spiegel 16. Die Welle 17 ist drehbar gelagert und mit dem Spiegel 16 verbunden, so dass der Spiegel 16 um eine Drehachse drehbar ist.

Die Sendeeinheit 8 ist in Fig. 1 nicht dargestellt, kann jedoch bezüglich des Spiegels 16 insbesondere derart angeordnet sein, dass bei Rotation des Spiegels 16 um die Drehachse der Aussendewinkel der Laserpulse 13 variiert wird. Die Drehachse und die Welle 17 sind also insbesondere senkrecht zu der Sendeebene des Sensorsystems 7 ausgerichtet.

Ein Empfangspfad für die reflektierten Anteile 14 der Laserpulse 13, welche beispielsweise von dem Objekt 15 reflektiert wurden, führt über den Spiegel 16 und die wenigstens eine Linse 18 zu der Empfangseinheit 9, insbesondere zu einer aktiven Oberfläche der Empfangseinheit 9. Die reflektierten Anteile 14 werden dann von mindestens einem der Detektoren 10, 11, 12 erfasst, indem die reflektierten Anteile 14 auf jeweilige individuelle aktive Oberflächen der Detektoren 10, 11, 12 treffen, welche die aktive Oberfläche des Sensorsystems 7 beziehungsweise der Empfangseinheit 9 bilden.

Durch die Rotation des Spiegels 16 um die Drehachse kann jeder der Detektoren 10, 11, 12 aus unterschiedlichen Richtungen einfallende reflektierte Anteile 14 der Laserpulse 13 detektieren. Die Momentanposition des Spiegels 16 kann dabei beispielsweise über einen mit der Welle 17 gekoppelten Drehgeber (nicht dargestellt) bestimmt werden.

Indem die Momentanposition des Spiegels 16 beispielsweise zu jedem Zeitpunkt bekannt ist, kann über die zeitliche Abfolge der detektierten reflektierten Anteile 14 eine Menge von Abtastpunkten, die auch als Punktwolke bezeichnet wird, erzeugt werden. Dabei wird mittels jedes Detektors 10, 11, 12 eine Untermenge der Abtastpunkte beziehungsweise der Punktwolke erzeugt. Eine Untermenge von Abtastpunkten, die mittels eines der Detektoren 10, 11, 12 erzeugt werden, kann auch als Lage von Abtastpunkten bezeichnet werden.

In Fig. 2 sind schematisch die Sendeeinheit 8 des Sensorsystems 7 sowie die Laserpulse 13 und das Objekt 15 gezeigt.

Die obere Abbildung in Fig. 2 entspricht beispielsweise einer Seitenansicht, also einer Ansicht mit einer Blickrichtung senkrecht zu der Drehachse und der Welle 17.

Die untere Abbildung in Fig. 2 entspricht beispielsweise einer Draufsicht auf die Sendeeinheit 8, also einer Ansicht mit Blickrichtung parallel zu der Welle 17.

Wie in den Abbildungen der Fig. 2 erkennbar ist, kann eine jeweilige Strahlaufweitung der Laserpulse in unterschiedlichen Ebenen unterschiedlich ausfallen.

In Fig. 1 ist auch eine Simulationsvorrichtung 22 nach dem verbesserten Konzept zum Simulieren einer Abtastung des Objekts 15 mit einem aktiven optischen Sensorsystem, welches beispielsweise gemäß dem beschriebenen aktiven optischen Sensorsystem 7 ausgebildet sein kann, dargestellt.

Die Simulationsvorrichtung 22 weist eine Recheneinheit 19 auf, welche beispielsweise als Prozessoreinheit mit einem oder mehreren Prozessoren eines Computersystems ausgestaltet sein kann. Die Simulationsvorrichtung 22 weist außerdem eine Speichereinheit 23 auf. Die Speichereinheit 23 kann optional als computerlesbares Speichermedium nach dem verbesserten Konzept ausgestaltet sein und entsprechend beispielsweise ein Computerprogramm nach dem verbesserten Konzept speichern.

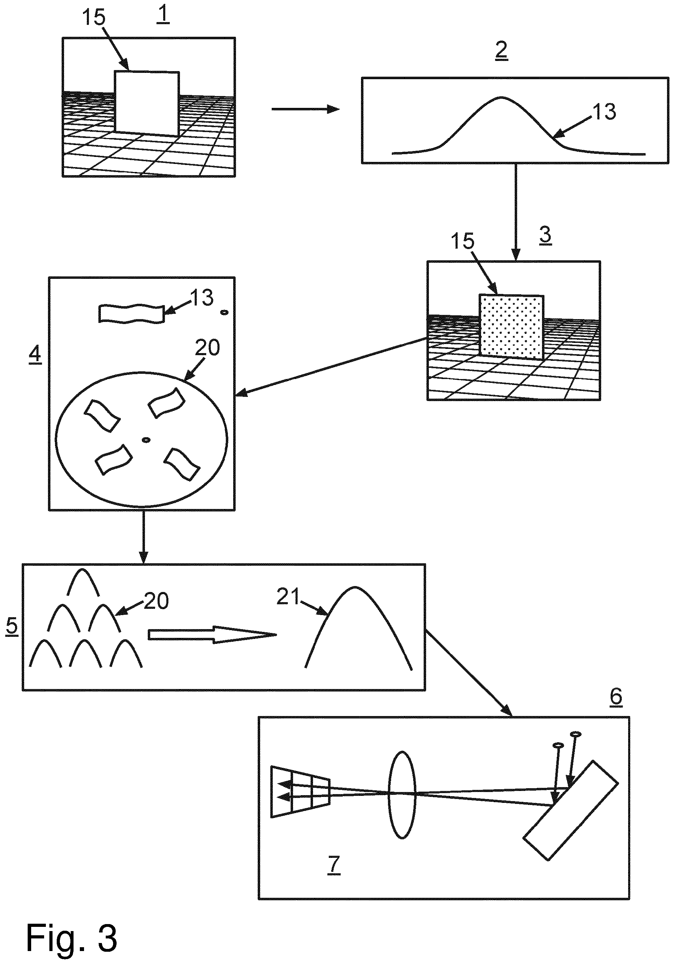

Die Funktionsweise der Simulationsvorrichtung 22 wird im Folgenden anhand einer beispielhaften Ausführungsform eines computerimplementierten Simulationsverfahrens zum Simulieren der Abtastung des Objekts erläutert, wie es schematisch in Fig. 3 gezeigt ist.

In Schritt 1 des Verfahrens liest die Recheneinheit 19 beispielsweise eine auf der Speichereinheit 23 gespeicherte Beschreibung einer Objektoberfläche des Objekts 15.

In Schritt 2 des Verfahrens liest die Recheneinheit 19 beispielsweise Parameter eines virtuellen Laserpulses 13, welche beispielsweise auf der Speichereinheit 23 gespeichert ist. Die Parameter können beispielsweise eine Aussenderichtung, eine Pulsform oder weitere Parameter des virtuellen Laserpulses 13 enthalten.

Die Intensität des virtuellen Laserpulses 13 kann beispielsweise quadratisch abfallen. Das bedeutet, dass die Intensität des Laserstrahls gemäß 1/R² abnimmt, wobei R einen Abstand vom Zentrum des virtuellen Laserpulses 13 beschreibt.

Optional kann die Recheneinheit 19 in Schritt 2 auch weitere Parameter lesen, die auf der Speichereinheit 23 gespeichert sind. Zu diesen weiteren Parametern können beispielsweise geometrische Parameter zur Beschreibung des Sensorsystems 7 und/oder des Objekts 15 oder Materialparameter zur Beschreibung des Sensorsystems 7 und/oder des Objekts 15 des virtuellen Laserpulses 13 beinhalten.

In Schritt 3 des Verfahrens berechnet die Recheneinheit 19 basierend auf der Beschreibung der Objektoberfläche eine Menge von diskreten Punkten auf der Objektoberfläche. Durch die diskreten Punkte wird die Objektoberfläche des Objekts 15 beispielsweise angenähert.

Für das Simulationsverfahren wird beispielsweise angenommen, dass jeder der diskreten Punkte auf der Objektoberfläche als freies oder quasifreies Elektron beschrieben werden kann. Dementsprechend wird angenommen, dass jeder Punkt der Objektoberfläche, auf den der virtuelle Laserpuls 13 trifft oder treffen würde, als Antwort auf den virtuellen Laserpuls 13 selbst eine Welle, insbesondere eine Kugelwelle, mit einer Wellenlänge aussendet, die durch die Wellenlänge des virtuellen Laserpulses 13 gegeben ist.

Dementsprechend wird in Schritt 4 des Verfahrens für jeden der Punkte mittels der Recheneinheit 19 eine Antwortfunktion 20 erzeugt, welche eine jeweilige Antwort auf den virtuellen Laserpuls 13 durch den entsprechenden diskreten Punkt beschreibt und insbesondere als Kugelwelle angenähert wird. Die Antwortfunktionen 20 werden insbesondere an der aktiven Oberfläche des Sensorsystems 7 berechnet.

Die in Schritt 2 optional bestimmten weiteren Materialparameter zur Beschreibung des Objekts können von der Recheneinheit 19 beispielsweise in Schritt 4 zur Berechnung der Antwortfunktionen 20 berücksichtigt werden.

In Schritt 5 des Verfahrens werden alle erzeugten Antwortfunktionen 20 summiert beziehungsweise überlagert, um eine Superpositionsfunktion 21 an der aktiven Oberfläche des Sensorsystems 7 zu erhalten. Dies kann insbesondere derart verstanden werden, dass sich alle individuellen Pulse, die durch die einzelnen Elektronen oder Punkte auf der Objektoberfläche ausgesendet werden und deren Licht auf die Detektoren 10, 11, 12 trifft, sich zu einem großen gemeinsamen Energie- oder Leistungspuls auf den Detektoren 10, 11, 12 beziehungsweise auf der aktiven Oberfläche summieren.

Die optional in Schritt 2 bestimmten geometrischen Parameter können von der Recheneinheit 19 beispielsweise in Schritt 5 zur Berechnung der Superposition 21 berücksichtigt werden.

Die optional in Schritt 2 bestimmten Materialparameter zur Beschreibung des Sensorsystems können von der Recheneinheit 19 ebenfalls beispielsweise in Schritt 5 zur Bestimmung der Superposition 21 berücksichtigt werden.

In Schritt 6 des Verfahrens berechnet die Recheneinheit 19 eine virtuelle Strahlungsleistung auf der aktiven Oberfläche des Sensorsystems 2, insbesondere auf den individuellen aktiven Oberflächen der Detektoren 10, 11, 12, abhängig von der Superposition.

Basierend auf der Strahlungsleistung kann die Recheneinheit beispielsweise entsprechende virtuelle Sensorsignale bestimmen.

Die beschriebenen Schritte können für unterschiedliche Aussenderichtungen des virtuellen Laserpulses wiederholt werden.

Indem die virtuelle Strahlungsleistung und die entsprechenden Sensorsignale für alle Detektoren 10, 11, 12 wiederholt für unterschiedliche Aussenderichtungen bestimmt werden, kann eine virtuelle Punktwolke des Objekts 15 erzeugt werden.

Insbesondere kann zum Erzeugen der virtuellen Punktwolke eine Lichtlaufzeit des Laserpulses 13 beziehungsweise der Antwortfunktionen 20 berücksichtigt werden, die ebenfalls mittels der Recheneinheit 19 berechnet werden kann. Da die Lichtlaufzeit einen Abstand zwischen dem entsprechenden Punkt auf der Objektoberfläche und dem Sensorsystem 7 entspricht, kann die Punktwolke als dreidimensionale Punktwolke bestimmt werden.

Anhand des verbesserten Konzepts wird eine realitätsnähe Simulation eines aktiven optischen Sensorsystems, insbesondere der Abtastung eines Objekts mit einem aktiven optischen Sensorsystem oder einer Kalibrierung des aktiven optischen Sensorsystems, bereitgestellt. Durch die damit erreichbare hohe Genauigkeit der Simulation können Kosten und Zeitaufwand bei der Entwicklung von aktiven optischen Sensorsystemen beziehungsweise bei der Entwicklung von Algorithmen zur Kalibrierung solcher Systeme oder zur Anwendung solcher Systeme reduziert werden.

## Patentansprüche

1. Computerimplementiertes Simulationsverfahren zum Simulieren einer Abtastung eines Objekts (15) mit einem aktiven optischen Sensorsystem (7),
**dadurch gekennzeichnet, dass**
- eine Beschreibung einer Objektoberfläche eines Objekts (15) vorgegeben wird;
- mittels einer Recheneinheit (19) basierend auf der Beschreibung der Objektoberfläche eine Menge von diskreten Punkten erzeugt wird;
- mittels der Recheneinheit (19) für jeden der Punkte eine Antwortfunktion (20) erzeugt wird, welche eine jeweilige Antwort auf einen virtuellen Laserpuls (13) beschreibt;
- mittels der Recheneinheit (19) eine Superposition (21) der erzeugten Antwortfunktionen (20) bestimmt wird; und
- mittels der Recheneinheit (19) eine virtuelle Strahlungsleistung auf einer aktiven Oberfläche des Sensorsystems (7) abhängig von der Superposition (21) bestimmt wird.

2. Computerimplementiertes Simulationsverfahren nach Anspruch 1,
**dadurch gekennzeichnet, dass**
- wenigstens ein geometrischer Parameter zur Beschreibung des Sensorsystems (7) und/oder des Objekts (15) vorgegeben wird; und
- die Superposition (21) mittels der Recheneinheit (19) abhängig von dem wenigstens einen geometrischen Parameter erzeugt wird.

3. Computerimplementiertes Simulationsverfahren nach einem der Ansprüche 1 oder 2,
**dadurch gekennzeichnet, dass**
- wenigstens ein Materialparameter zur Beschreibung des Sensorsystems (7) vorgegeben wird; und
- die Superposition (21) mittels der Recheneinheit (19) abhängig von dem wenigstens einen Materialparameter bestimmt wird.

4. Computerimplementiertes Simulationsverfahren nach einem der Ansprüche 1 bis 3,
**dadurch gekennzeichnet, dass**
- wenigstens ein weiterer Materialparameter zur Beschreibung des Objekts (15) vorgegeben wird; und
- die Antwortfunktionen (20) mittels der Recheneinheit (19) abhängig von dem wenigstens einen weiteren Materialparameter bestimmt werden.

5. Computerimplementiertes Simulationsverfahren nach einem der Ansprüche 1 bis 4,
**dadurch gekennzeichnet, dass**
mittels der Recheneinheit (19) abhängig von der virtuellen Strahlungsleistung wenigstens ein virtuelles Sensorsignal erzeugt wird.

6. Computerimplementiertes Simulationsverfahren nach einem der Ansprüche 1 bis 4,
**dadurch gekennzeichnet, dass** mittels der Recheneinheit (19)
- die virtuelle Strahlungsleistung auf der aktiven Oberfläche abhängig von der Superposition (21) ortsabhängig bestimmt wird; und
- abhängig von der ortsabhängigen virtuellen Strahlungsleistung wenigstens zwei virtuelle Sensorsignale erzeugt werden.

7. Computerimplementiertes Simulationsverfahren nach einem der Ansprüche 1 bis 6,
**dadurch gekennzeichnet, dass**
- eine Aussenderichtung des virtuellen Laserpulses (13) vorgegeben wird; und
- die Antwortfunktionen (20) mittels der Recheneinheit (19) abhängig von der Aussenderichtung erzeugt werden.

8. Computerimplementiertes Simulationsverfahren nach einem der Ansprüche 1 bis 7,
**dadurch gekennzeichnet, dass** mittels der Recheneinheit (19)
- eine Lichtlaufzeit abhängig von der Beschreibung der Objektoberfläche berechnet wird; und
- abhängig von der Lichtlaufzeit und der virtuellen Strahlungsleistung ein Abtastpunkt einer virtuellen Punktwolke erzeugt wird.

9. Computerimplementiertes Simulationsverfahren zum Simulieren einer Kalibrierung eines aktiven optischen Sensorsystems (7),
**dadurch gekennzeichnet, dass**
- eine Abtastung eines Objekts (15) anhand eines computerimplementierten Simulationsverfahrens nach einem der Ansprüche 1 bis 8 simuliert wird;
- mittels der Recheneinheit (19) abhängig von der Abtastung eine virtuelle Punktwolke von Abtastpunkten erzeugt wird;
- mittels der Recheneinheit (19) abhängig von der virtuellen Punktwolke eine virtuelle Winkellage des Sensorsystems (7) bestimmt wird.

10. Computerimplementiertes Simulationsverfahren nach Anspruch 9,
**dadurch gekennzeichnet, dass**
- die Abtastung mehrfach anhand eines computerimplementierten Simulationsverfahrens mit den Merkmalen der Ansprüche 6, 7 und 8 simuliert wird, wobei für jede Simulation ein anderer Wert für die Aussenderichtung vorgegeben wird; und
- mittels der Recheneinheit (19) abhängig von der mehrfach simulierten Abtastung die virtuelle Punktwolke erzeugt wird.

11. Simulationsvorrichtung zum Simulieren einer Abtastung eines Objekts (15) mit einem aktiven optischen Sensorsystem (7), die Simulationsvorrichtung (22) aufweisend eine Speichereinheit (23) und eine Recheneinheit (19), die auf die Speichereinheit (23) zugreifen kann,
**dadurch gekennzeichnet, dass**
- auf der Speichereinheit (23) eine Beschreibung einer Objektoberfläche eines Objekts (15) des Sensorsystems (7) gespeichert ist; und
- die Recheneinheit (19) dazu eingerichtet ist,
- basierend auf der Beschreibung der Objektoberfläche eine Menge von diskreten Punkten zu erzeugen;
- für jeden der Punkte eine Antwortfunktion (20) zu erzeugen, welche eine jeweilige Antwort auf den virtuellen Laserpuls (13) beschreibt;
- eine Superposition (21) der erzeugten Antwortfunktionen (20) zu bestimmen; und
- eine virtuelle Strahlungsleistung auf einer aktiven Oberfläche des Sensorsystems (7) abhängig von der Superposition (21) zu bestimmen.

12. Simulationsvorrichtung nach Anspruch 11,
**dadurch gekennzeichnet, dass**
- die Recheneinheit (19) dazu eingerichtet ist, die virtuelle Strahlungsleistung auf der aktiven Oberfläche abhängig von der Superposition (21) ortsabhängig zu bestimmen und abhängig von der ortsabhängigen virtuellen Strahlungsleistung wenigstens zwei virtuelle Sensorsignale zu erzeugen; und/oder
- auf der Speichereinheit (23) eine Aussenderichtung des virtuellen Laserpulses (13) gespeichert ist und die Recheneinheit (19) dazu eingerichtet ist, die Antwortfunktionen (20) abhängig von der Aussenderichtung zu erzeugen; und/oder
- die Recheneinheit (19) dazu eingerichtet ist, eine Lichtlaufzeit abhängig von der Beschreibung der Objektoberfläche zu berechnen und abhängig von der Lichtlaufzeit und der virtuellen Strahlungsleistung einen Abtastpunkt einer virtuellen Punktwolke zu erzeugen.

13. Simulationsvorrichtung nach Anspruch 12,
**dadurch gekennzeichnet, dass**
die Recheneinheit (19) dazu eingerichtet ist, abhängig von der virtuellen Punktwolke eine virtuelle Winkellage des Sensorsystems (7) zu bestimmen.

14. Computerprogramm mit Befehlen, welche bei Ausführung des Computerprogramms durch ein Computersystem das Computersystem dazu veranlassen, ein computerimplementiertes Simulationsverfahren nach einem der Ansprüche 1 bis 10 durchzuführen.

15. Computerlesbares Speichermedium auf welchem ein Computerprogramm nach Anspruch 14 gespeichert ist.
